(19) **Europäisches Patentamt / European Patent Office / Office européen des brevets**

(11) **EP 1 265 076 B1**

(12) **EUROPEAN PATENT SPECIFICATION**

(45) Date of publication and mention
of the grant of the patent:
**31.12.2008 Bulletin 2009/01**

(21) Application number: **01870121.9**

(22) Date of filing: **08.06.2001**

(51) Int Cl.:
*G01R 27/18* (2006.01)   *G01R 31/12* (2006.01)

(54) **Safety device for monitoring a DC bus insulation**

Sicherheitsvorrichtung für die Überwachung einer Gleichspannungsbusisolation

Dispositif de sécurité pour tester l'isolation d'une heare omnibus à courent continue

(84) Designated Contracting States:
**AT BE CH CY DE DK ES FI FR GB GR IE IT LI LU MC NL PT SE TR**

(43) Date of publication of application:
**11.12.2002 Bulletin 2002/50**

(73) Proprietor: **"VLAAMSE INSTELLING VOOR TECHNOLOGISCH ONDERZOEK", afgekort "V.I.T.O." 2400 Mol (BE)**

(72) Inventors:
• **Van Tichelen, Paul B-3001 Leuven (BE)**

• **Weyen, Dominique B-3920 Lommel (BE)**

(74) Representative: **Van Malderen, Joëlle et al pronovem - Office Van Malderen Avenue Josse Goffin 158 1082 Bruxelles (BE)**

(56) References cited:
**EP-A- 0 833 423     DE-A- 2 753 572**
**DE-A- 3 513 849**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Field of the invention

The present invention is related to devices for monitoring insulation faults of electrical systems, in particular of DC systems. The monitoring comprises both measuring of insulation quality as well as actuating interruption relays or the like when insulation failure is detected.

### State of the art

A DC bus insulation fault detection device protects users and equipment against electrical hazards by monitoring insulation faults. If an insulation fault occurs between the DC bus and protective earth, the DC source is switched off with a relay and a warning signal occurs. The term 'protective earth' can be a real earth connection but in most cases it refers to a metal enclosure. Insulation monitoring devices can be used for safety in electrical vehicles or large solar panel arrays with unsafe high DC voltages, wherein the DC bus is left floating with respect to the metal chassis or metal enclosure. Insulation faults can occur when persons have direct contact with conductors of the DC bus or when the insulation fails between the DC bus conductors and the metal enclosure. Insulation safety devices have been described, e.g. in document EP-A-0654673. This document describes a method and device wherein a switchable voltage source is used which can produce one of two different DC voltages as a function of a control signal. The device then determines the ohmic impedance between a network to be monitored and earth from the difference between two sequential current measurements. As in many other devices known in the art, a separate switchable voltage source is needed here, which increases the complexity of the device. Document EP833423 describes an apparatus and a method for monitoring an earth-leakage state of a power distribution system. The device comprises two resistors in series with two switches, coupled between earth and the two conductors of a DC-bus. The presence of two switches makes it necessary to provide two measurement systems, or additional switches, so that the hardware of such a device becomes rather complex.

### Aims of the invention

The present invention aims to provide a new insulation safety method and a device to perform said method, which is less complex than existing devices.

### Summary of the invention

The present invention is related to a method for monitoring insulation faults occurring between a DC bus and protective earth, said bus being in connection with a DC source, said method comprising the steps of :

- connecting the terminals of said source to protective earth by a first network during a first timespan,
- measuring at least one stable electrical value related to said first network, during said first timespan,
- connecting the terminals of said source to protective earth by a second network, during a second timespan,
- measuring at least one stable electrical value related to said second network, during said second timespan,
- calculating from said measured values, the insulation resistances between each of the terminals of said source and protective earth,
- comparing said insulation resistances to predefined alarm levels,
- performing an alarm action, when said insulation resistances exceed predefined levels.

**characterized in that** :

- one switch is used in such a way that said step of connecting said terminals to said first network is done by putting said switch into a first state, and said step of connecting said terminals to said second network is done by putting said switch into a second state,
- said electrical value related to said first and second networks are measured at the same measurement point, with respect to the same reference. According to a preferred embodiment, this reference is protective earth.

Preferably, said alarm action comprises the disconnection of said source from loads connected to said source.

According to a preferred embodiment, the resistance value R1.R2/(R1+R2) equivalent to the parallel connection of said resistance values is compared to an alarm level for said value equivalent to said parallel connection.

According to a preferred embodiment, said measured values are measured voltages.

According to a preferred embodiment, said first and second timespans are equal and the sequence of said first and second timespan is repeated with a fixed frequency, and said steps of measuring, calculating and comparing are repeated with said same frequency.

The present invention is equally related to a device essentially for monitoring insulation faults occurring between a DC bus and protective earth, said bus being in connection with a DC source, connected to a main switch, according to the method of the invention, said device comprising :

- a switch,
- an electrical network, connected to said switch,
- a microntroller, able to control said switch through a connection, said microcontroller comprising means for measuring an electrical value,

- at least one connection between said network and said microcontroller, each connection being used for measuring one value,
- means for connecting said device to the terminals of said source, to protective earth, and to a relay which controls said main switch,

wherein said switch's first state transforms said electrical network into said first network,
and wherein said switch's second state transforms said electrical network into said second network,
and wherein said microcontroller performs said measurement of said measured values, and
wherein said microcontroller equally performs said steps of calculating the insulation resistance values and comparing them to predefined alarm levels
and wherein said microcontroller equally actuates said step of performing an alarm action, at least by opening the main switch of said DC source.

According to a preferred embodiment, said switch is a transistor Q1 and said electrical network comprises :

- a resistor R3 connected between the positive terminal of the source and protective earth,
- a first pair of resistors (R4, R8) in series, connected between the negative terminal of the source and protective earth,
- a resistor R7, placed in series with said transistor Q1, so that the series connection of said resistor and said transistor Q1 is placed in parallel to said first pair of resistors (R4, R8) in series,
- a capacitor C1 in parallel with said resistor R7 and said transistor Q1,
- a second pair of resistors (R5, R6) in series, said second pair of resistors (R5, R6) being connected to the source,
- a connection between the microcontroller and the point between the resistors of said first pair of resistors (R4, R8) in series, for measuring a voltage,
- a connection between the microcontroller and the point between the resistors of said second pair of resistors (R5, R6) in series, and a connection between the microcontroller and the negative source terminal, for measuring a voltage.

According to the preferred embodiment, the following relations are true :

$$R4+R8 \ = \ 2*R3$$

$$R7 \ = \ 2*R3/3$$

$$R8 \ = \ R4/100$$

According to another embodiment, the microcontroller is programmed or designed in such a way that the device, upon being turned on, closes the main switch, thereby starting said insulation fault monitoring. The microcontroller may be programmed or designed in such a way that said main switch is opened when the power generated by said source is lower than a predefined level.

A device according to the invention may further comprise means for sending a low voltage signal towards a load, after opening of said main switch due to an insulation failure.

A device according to the invention may further comprise means for connecting said device to at least one additional relay. Said microcontroller is then programmed or designed to operate said additional relay(s) at a given moment in time. The invention is equally related to the use of a such a device

- for operating an additional relay before the main switch is closed, thereby closing a switch, for reducing the inrush current on a DC bus capacitor, and/or
- for operating an additional relay after the main switch is opened, thereby closing a switch, for discharging capacitive voltage on the DC bus.

In a device according to the invention, said switch may be a transistor.

### Short description of the drawings

Figure 1 represents the general schematic view of a device according to the invention.
Figure 2 represents the circuit of a device according to a preferred embodiment of the invention.
Figures 3 and 4 illustrate typical applications of a device according to the invention, equipped with additional capabilities besides the monitoring of insulation faults.

### Detailed description of the invention

The present invention is related to a method and a device used for monitoring insulation faults occurring between a DC bus and 'protective earth', which is for example a metal enclosure. The method of the invention, as disclosed in the paragraph entitled 'summary of the invention', is based on the principle of connecting at least two different electrical networks to a DC source, and measuring at least one value related to each network. Subsequently, these values are used to calculate the equivalent insulation resistances between the DC bus and protective earth, after which an alarm action can be taken, should these resistances become too low due to an insulation failure.

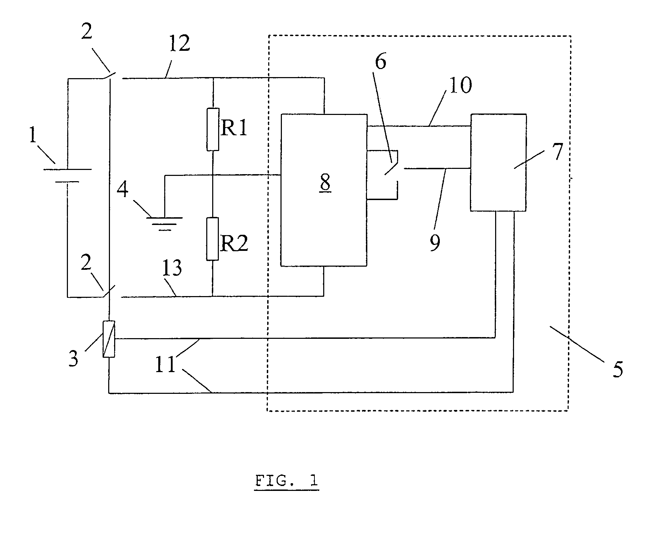

The principle of the device of the invention is shown in figure 1. A DC power source 1 is present, connected to one or more loads (not shown) via a DC bus comprising conductors 12 and 13. The main switch for connecting or disconnecting the source 1 to this load is represented by two synchronised switches 2, one placed in each of the conductors of the DC bus and operated by a relay 3. The insulation of the DC bus connected to the source 1 is schematically represented as a pair of resistors R1 and R2, between the source's terminals and protective earth 4. The insulation between the DC bus and protective earth is influenced by the insulation of the conductors 12 and 13, and all conductors leading to loads , as well as to the insulation of DC systems (motors or other machinery) comprised in these loads. It is to be noted that the denomination 'protective earth' may relate to the chassis of a car or any protective enclosure, as well as a real connection to earth, depending on the application. The problem to be solved is how to determine the resistance values of R1 and R2. The device 5 of the invention is connected to the source as shown in figure 1. It comprises a switching device 6 and a microcontroller 7, as well as a circuit 8 comprising essentially a network of resistances, capacities and/or inductors. No separate voltage source is needed, apart from the supply for the microcontroller (not shown).

The switching device 6, which might be a bipolar transistor or a MOSFET, is controlled by the microcontroller 7, which commands the 'on' or 'off' state of the switch 6 through connection 9. The state of the switch 6 defines the actual circuit connected to the source at any point in time. This means that by controlling the switch 6, two different electrical networks can be created.

Means are provided in the microcontroller 7 to measure a value, preferably a voltage at a particular point in the circuit. This measurement value is acquired through connection 10. The circuit is devised in such a way that two sufficiently distinct values are measured at the same point during each state (on or off) of the switch 6. If necessary, more than two values may be measured, for example one additional measurement value which is independent of the state of the switch 6, or two additional values that are dependent on the state of the switch 6, or both.

The unknown resistance values of R1 and R2 are calculated on the basis of these at least two measurement values, combined with the network laws applied to the two different networks corresponding respectively to the switch being on or off.

The calculation of R1 and R2, according to the appropriate formulas, is performed by the microcontroller 7. A check is done by the microcontroller whether the values of R1 and R2 are sufficiently high. If not, an insulation failure is detected and the relay 3 is activated through connection 11, disconnecting the terminals of the source 1 from any load connected to these terminals. Possibly, a pre-alarm warning signal may be activated when R1 and R2 are near the predefined alarm level, but not yet underneath said alarm level.

Any calculation of R1 and R2 takes two consecutive measurements, each during one condition (on or off) of the switch 6. A continuous monitoring is done by changing the condition of the switch in a sequential manner and with a given frequency.

The simplicity of this solution is apparent. A simple switch and a microcontroller replace the often complex structures used in the state of the art.

This device can also perform other safety functions useful for dedicated applications, e.g.: under and over voltage protection, temperature measurement, self-testing, warning level indication.... This can be done simply by re-programming the micro-controller, or by using a microcontroller designed to perform additional measurements, calculations and/or actuate additional command signals for relays or the like so that values other than the insulation resistances R1 and R2 are calculated, in addition to R1 and R2. A plurality of values that are to be checked, may be calculated by the microcontroller 7, which may then activate a number of safety measures : relays for interrupting current, alarm signals, etc...

A device according to the invention can also operate an extra relay that prevents excessive inrush currents on DC bus capacitors. It can also discharge residual voltage on DC bus capacitors after switching off the main switch by operating an extra relay.

In some applications, for example when the source voltage 1 is generated by an array of solar panels, the device of the invention may be programmed to disconnect the source, in case of low power generation. This action needs a hysteresis applied to it, based on a delay time or a voltage level, in order to prevent excessive switching of the main switch 2.

A device of the invention may be equipped with means for sending a signal to a load connected to the DC source, in case of an insulation failure, for communicating said failure to remote control stations.

## Description of a preferred embodiment of the invention

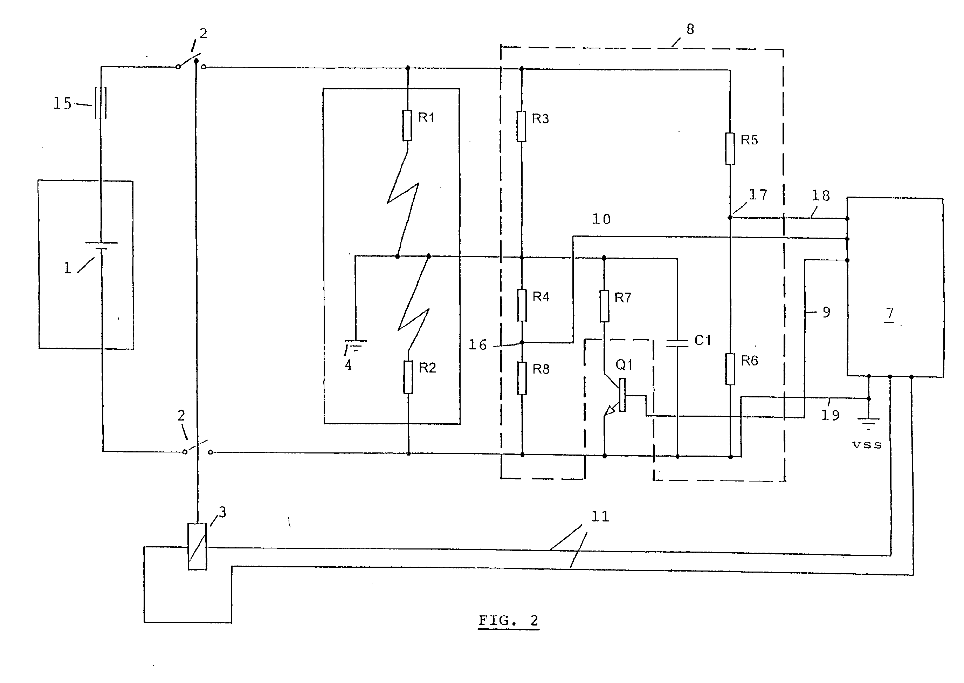

Figure 2 shows a typical embodiment of the safety device according to the invention. Two resistances (R1, R2) representing the insulation between the DC bus terminals (+, -) of the DC source 1 and protective earth 4 have to be monitored. The switch 6 is now a transistor Q1. The electrical network 8 is delimited by the dotted line. In this embodiment, this network comprises :

- a resistor R3 between the positive source terminal and protective earth 4,
- two resistors R4 and R8 in series, between the negative source terminal and protective earth 4,
- a resistor R7 in series with Q1 so that R7 and Q1 are placed in parallel with the resistors R4 and R8.
- two resistors R5 and R6 in series, and as such connected to the terminals of the source 1.

When Q1 is off, the resistor divider network comprises only the resistors R3, R4 and R8. Activation of Q1 brings the parallel branch containing R7 into play. In both conditions, the microcontroller measures the voltages with respect to protective earth at the position 16, which is the point between series resistors R4 and R8. This configuration as a resistor divider network allows to reduce the measured voltage to a sufficiently low value, measurable by the microcontroller's circuits. Two consecutive voltage measurements give two values, which are used to calculate R1 and R2, as explained after this. The capacitor C1 is included for the filtering of high frequency noise. A fuse 15 is present as an added safety.

In the embodiment of figure 2, an additional voltage measurement is done with respect to the negative terminal, at point 17 between series resistors R5 and R6. This measurement is done via the connections 18 and 19. This is done in order to allow the microcontroller to establish at each moment the correct DC voltage Vdc, produced by the source. If the voltage measured at point 17 is called Vm, the following is true :

$$Vdc = \frac{Vm * (R5 + R6)}{R6}$$

The following definitions are now put forward :

V1' = Voltage at point 16 with Q1 off
V2' = Voltage at point 16 with Q1 on

According to this embodiment, the resistance values are chosen such that :

-

$$R4 + R8 = 2 * R3$$

-

$$R7 = 2 * R3 / 3$$

-

$$R8 = R4 / 100$$

By applying these relations and the network laws in each of the two networks, the person skilled in the art is able to derive that the following formulas are true :

$$R1 = \frac{R3}{\left( \frac{R3}{\left( \frac{1}{v1} - 1 \right) * \frac{2 * R3 * R2}{(2 * R3 + R2)}} - 1 \right)}$$

and :

$$R2 = \frac{R3 * \left( \frac{1}{v2} - \frac{1}{v1} \right)}{\left( \frac{2}{v1} - \frac{1}{2 * v2} - \frac{3}{2} \right)}$$

wherein

$$v1 = (V1' * 100)/Vdc$$

$$v2 = (V2' * 100)/Vdc$$

The microcontroller is programmed to calculate these values after determining V1', V2' and Vdc. If the values of R1 and R2 do not reach a predefined level, an alarm signal is given and the relay 3 activated. According to the preferred embodiment, the microcontroller does not check the two values of R1 and R2 individually, but the value equivalent to a parallel connection of R1 and R2, namely :

$$\frac{R1.R2}{R1 + R2}$$

Because this value is smaller than either R1 or R2, this leads to a stricter safety criterion, apart from providing the convenience of having to check only one value instead of two.

In normal operation, a device according to the invention switches at fixed intervals between the conditions 'Q1 on' and 'Q1 off' , for example with a frequency of 10Hz. In the case of the device in figure 2, a measurement of the voltage at point 16 (either V1' or V2'), and at point 17 (Vm) is then done approximately every 100ms, and a calculation of R1 and R2 every 200ms. Ideally, the measurements are performed after a given delay (e.g. 50ms) after switching of Q1, to allow a stable voltage to develop at each of the measuring points 16 and 17.

## Examples of application of a device according to the invention.

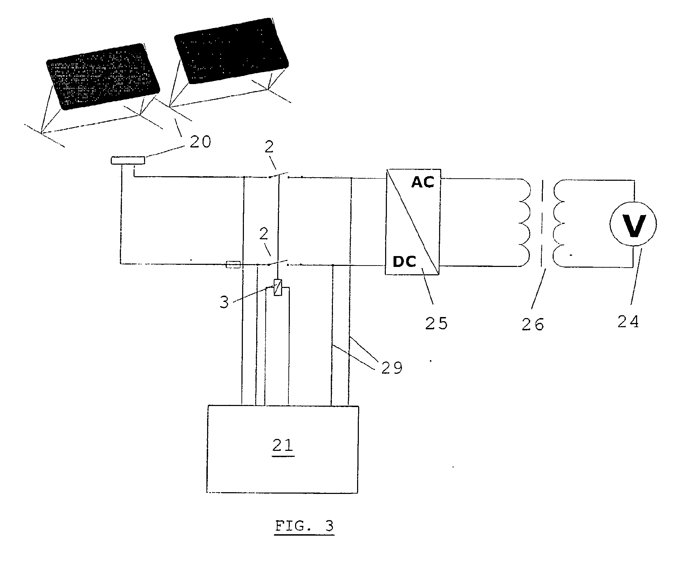

Figure 3 illustrates a device of the invention equipped with an additional feature, besides the monitoring of insulation faults. An array 20 of photovoltaic cells (solar panels) is generating the source voltage. A device 21 according to the invention is connected to the terminals of this source. A relay 3 is operated by the device to interrupt the main switch 2 in case of insulation failure or low power. The DC source is connected to a load 24, in this case the AC grid, via an inverter 25 and an insulation transformer 26. The device of the invention sends a low voltage signal via the connections 29 towards the inverter 25, as soon as the main switch is opened due to a failure (not due to low power) . The inverter 25 may be situated at a considerable distance from the solar panels 20. This signal serves as a warning signal, and is for example communicated to an operator, signalling him that the breakdown of power coming from a particular source is due to an insulation failure.

The low voltage signal is preferably generated starting from the supply voltage (e.g. 12 V) of the microcontroller. Suitable means known in the art, for transmitting the warning signal after a failure are included in the device 21.

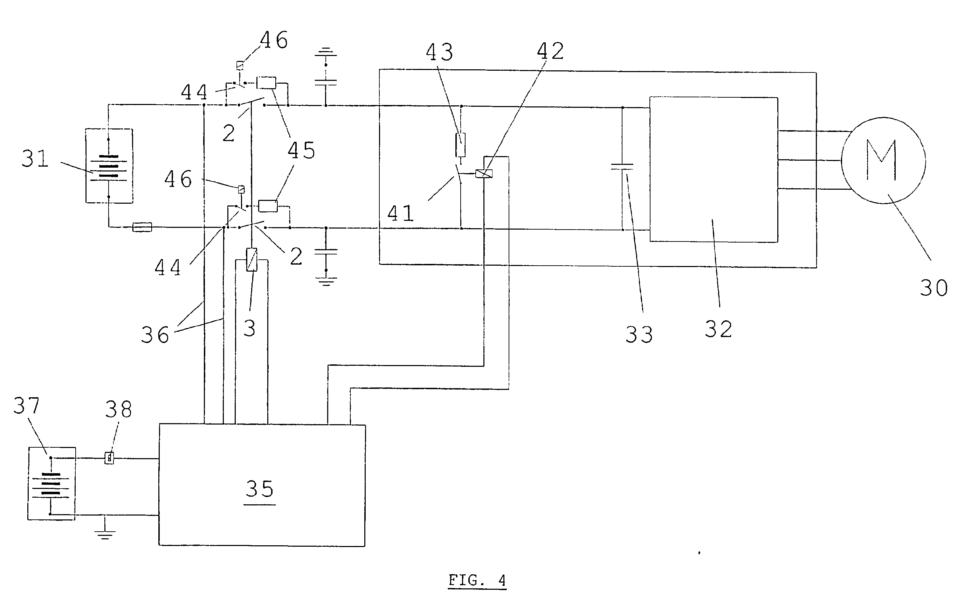

Figure 4 illustrates the application of a device of the invention in the control of an electrical motor 30. The source 31 (e.g. 400V DC) is powering a motor controller 32. A DC bus capacitor 33 is connected between the input terminals of the motor controller, in order to compensate for potential voltage fluctuations. A device 35 according to the invention is connected to the terminals of the source 31 by connections 36. Once more, a relay 3 may operate the main switch 2, upon a signal from the device 35. The device 35 itself, in particular the microcontroller comprised in it, is powered by a separate DC source 37 (typically 12V). In this embodiment, the ignition key 38 is provided as a switch for turning on the safety device. This means that the safety device is powered first, and in turn, when the insulation is proven to be up to standard, the safety device allows the supply of power to the motor. Provision must be made here to make sure that as soon as the power to the safety device is interrupted, the main switch 2 is opened as well.

During operation of the motor, the insulation is continuously monitored in the manner described in the previous paragraphs. The relay 3 is operated to open the main switch 2, if an insulation failure is detected. The device 35 is however programmed to perform two additional actions. After it has opened the main switch 2, for example after an insulation failure, it closes another switch 41, by operating a relay 42. This ensures the easy discharge of the DC bus capacitor 33 over the bleeder resistor 43 in series with the switch 41.

Additional switches 44 and resistors 45 are present in parallel to the main switch 2. These switches 44 are operated by relays 46. These switches allow a pre-charging of the capacitor 33 before closing of the main switch, thereby avoiding excessive inrush current towards said capacitor. The relays 46 operating said switches 44 are also commanded by the device of the invention (connections to relays 46 not shown in drawing).

These features can be easily programmed into the microcontroller 7 of the device 35, which will introduce a delay before closing the main switch 2, until the precharging of 33 via switches 44 is completed. Likewise, the microcontroller is programmed to close the switch 41, immediately after opening the main switch 2.

## Claims

1. A method for monitoring insulation faults occurring between a DC bus and protective earth, said bus being in connection with a DC source (1), said method comprising the steps of :

   - connecting the terminals of said source (1) to protective earth (4) by a first electrical network during a first timespan,
   - measuring at least one stable electrical value (V1', Vdc) related to said first network, during said first timespan,
   - connecting the terminals of said source (1) to protective earth (4) by a second electrical network, during a second timespan,
   - measuring at least one stable electrical value (V2', Vdc) related to said second network, during said second timespan,
   - calculating from said measured values, the insulation resistances (R1, R2) between each of the terminals of said source (1) and protective earth (4)
   - comparing said insulation resistances (R1, R2) to predefined alarm levels,
   - performing an alarm action, when said insulation resistances (R1, R2) exceed predefined levels.

   **characterized in that** :

   - one switch (6) is used in such a way that said step of connecting said terminals to said first network is done by putting said switch (6) into a first state, and said step of connecting said terminals to said second network is done by putting said switch (6) into a second state,
   - said electrical value related to said first and second networks are measured at the same measurement point (16), with respect to the same reference.

2. A method according to claim 1, wherein said reference is protective earth.

3. A method according to claim 1, wherein said alarm action is the disconnection of said source (1) from loads connected to said source.

4. A method according to any one of the preceding claims, wherein the resistance value R1.R2/(R1+R2) equivalent to the parallel connection of said resistance values (R1, R2) is compared to an alarm level for said value equivalent to said parallel connection.

5. A method according to any one of the preceding claims, wherein said measured values are measured voltages.

6. A method according to any one of the preceding claims, wherein said first and second timespans are equal and wherein the sequence of said first and second timespan is repeated with a fixed frequency, and wherein said steps of measuring, calculating and comparing are repeated with said same frequency.

7. A device essentially for monitoring insulation faults occurring between a DC bus and protective earth, said bus being in connection with a DC source (1), connected to a main switch (2), according to the method of any one of the preceding claims, said device comprising :

   - one switch (6),
   - an electrical network (8), connected to said switch (6),
   - a microcontroller (7), able to control said switch (6) through a connection (9), said microcontroller comprising means for measuring an electrical value,
   - at least one connection (10) between said network (8) and said microcontroller (7), each connection being used for measuring one value,
   - means for connecting said device to the terminals of said source (1), to protective earth (4), and to a relay (3) which controls said main switch (2),

   wherein said switch's (6) first state transforms said electrical network (8) into said first network,
   and wherein said switch's second state transforms said electrical network (8) into said second network,
   and wherein said microcontroller (7) performs said measurement of said measured values, and
   wherein said microcontroller (7) equally performs said steps of calculating the insulation resistance values (R1, R2) and comparing them to predefined alarm levels
   and wherein said microcontroller (7) equally actuates said step of performing an alarm action, at least by opening the main switch (2) of said DC source (1).

8. A device according to claim 7, wherein said switch (6) is a transistor (Q1) and wherein said electrical network (8) comprises :

   - a resistor R3 connected between the positive terminal of the source (1) and protective earth (4),
   - a first pair of resistors (R4, R8) in series, connected between the negative terminal of the source (1) and protective earth (4),
   - a resistor (R7), placed in series with said transistor (Q1), so that the series connection of said resistor (R7) and said transistor (Q1) is placed in parallel to said first pair of resistors (R4, R8) in series,
   - a capacitor (C1) in parallel with said resistor (R7) and said transistor (Q1),
   - a second pair of resistors (R5, R6) in series, said second pair of resistors (R5, R6) being connected to the source (1),
   - a connection (10) between the microcontroller (7) and the point (16) between the resistors of said first pair of resistors (R4, R8) in series, for measuring a voltage (V1', V2'),
   - a connection (18) between the microcontroller (7) and the point (17) between the resistors of said second pair of resistors (R5, R6) in series, and a connection (19) between the microcontroller (7) and the negative source terminal, for measuring a voltage (Vm).

9. A device according to claim 8, wherein the following relations are true :

$$R4+R8 = 2*R3$$

$$R7 = 2*R3/3$$

$$R8 = R4/100$$

10. A device according to any one of the claims 7 to 9, wherein the microcontroller (7) is programmed or designed in such a way that the device, upon being turned on, closes the main switch (2), thereby starting said insulation fault monitoring.

11. A device according to any one of the claims 7 to 10, wherein the microcontroller (7) is programmed or designed in such a way that said main switch (2) is opened when the power generated by said source is lower than a predefined level.

12. A device according to any one of claims 7 to 11, further comprising means for sending a low voltage signal towards a load, after interruption of said main switch (2) due to an insulation failure.

13. A device according to any one of claims 7 to 12, further comprising means for connecting said device to at least one additional relay (42,46), and wherein said microcontroller (7) is programmed or designed to operate said additional relay(s) at a given moment in time.

14. Use of a device according to claim 13,

- for operating an additional relay (46) before the main switch (2) is closed, thereby closing a switch (44), for reducing the inrush current on a DC bus capacitor (33), and/or

- for operating an additional relay (42) after the main switch (2) is opened, thereby closing a switch (41), for discharging capacitive voltage on the DC bus.

15. A device according to any one of claims 7 to 13, wherein said switch (6) is a transistor (Q1).


**Patentansprüche**

1. Verfahren zum Überwachen von Isolationsfehlern, welche zwischen einem DC-Bus und Schutzerdung auftreten, wobei der Bus mit einer Gleichstromquelle (1) in Verbindung steht, wobei das Verfahren die Schritte umfasst:

    - Verbinden der Anschlüsse der Quelle (1) mit Schutzerdung (4), durch ein erstes elektrisches Netzwerk, während einer ersten Zeitspanne,
    - Messen wenigstens eines stabilen elektrischen Werts (V1', Vdc), in Beziehung zu dem ersten Netzwerk, während der ersten Zeitspanne,
    - Verbinden der Anschlüsse der Quelle (1) mit Schutzerdung (4), durch ein zweites elektrisches Netzwerk, während einer zweiten Zeitspanne,
    - Messen wenigstens eines stabilen elektrischen Werts (V2', Vdc), in Beziehung zu dem zweiten Netzwerk, während der zweiten Zeitspanne,
    - Berechnen, aus den gemessenen Werten, des Isolationswiderstands (R1, R2), zwischen jedem der Anschlüsse der Quelle (1) und Schutzerdung (4),
    - Vergleichen der Isolationswiderstände (R1, R2) mit vordefinierten Alarmniveaus,
    - Ausführen einer Alarmaktion, wenn die Isolationswiderstände (R1, R2) vordefinierte Niveaus übersteigen,

    **dadurch gekennzeichnet, dass:**

    - ein Schalter (6) derart verwendet wird, dass der Schritt des Verbindens der Anschlüsse mit dem ersten Netzwerk durch Bringen des Schalters (6) in einen ersten Zustand erfolgt, und der Schritt des verbindens der Anschlüsse mit dem zweiten Netzwerk durch Bringen des Schalters (6) in einen zweiten Zustand erfolgt,
    - die elektrischen werte, in Beziehung zu dem ersten und dem zweiten Netzwerk, an demselben Messpunkt (16) gemessen werden, bezogen auf dieselbe Referenz.

2. Verfahren nach Anspruch 1, wobei die Referenz Schutzerdung ist.

3. Verfahren nach Anspruch 1, wobei die Alarmaktion das Trennen der Quelle (1) von Lasten ist, welche mit der Quelle verbunden sind.

4. Verfahren nach einem der vorhergehenden Ansprüche, wobei der Widerstandswert R1.R2/(R1+R2), welcher äquivalent der Parallelschaltung der Widerstandswerte (R1, R2) ist, mit einem Alarmniveau für den Wert, welcher äquivalent der Parallelschaltung ist, verglichen wird.

5. Verfahren nach einem der vorhergehenden Ansprüche, wobei die gemessenen Werte gemessene Spannungen sind.

6. Verfahren nach einem der vorhergehenden Ansprüche, wobei die erste und die zweite Zeitspanne gleich sind, und wobei die Abfolge der ersten und der zweiten Zeitspanne mit einer festgesetzten Frequenz wiederholt wird, und wobei die Schritte des Messens, des Berechnens und des Vergleichens mit derselben Frequenz wiederholt werden.

7. Vorrichtung, im Wesentlichen zum Überwachen von Isolationsfehlern, welche zwischen einem DC-Bus und Schutzerdung auftreten, wobei der Bus mit einer Gleichstromquelle (1) in Verbindung steht, welche mit einem Hauptschalter (2) verbunden ist, gemäß dem Verfahren nach einem der vorhergehenden Ansprüche, wobei die Vorrichtung umfasst:

    - einen Schalter (6),
    - ein elektrisches Netzwerk (8), welches mit dem Schalter (6) verbunden ist,
    - einen Mikrocontroller (7), welcher in der Lage ist, den Schalter (6) durch eine Verbindung (9) zu steuern, wobei der Mikrocontroller Mittel zum Messen eines elektrischen Werts umfasst,
    - wenigstens eine Verbindung (10), zwischen dem Netzwerk (8) und dem Mikrocontroller (7), wobei jede Verbindung zum Messen eines Werts verwendet wird,
    - Mittel zum Verbinden der Vorrichtung mit den Anschlüssen der Quelle (1), mit Schutzerdung (4) und mit einem Relais (3), welches den Hauptschalter (2) steuert,

wobei der erste Zustand des Schalters (6) das elektrische Netzwerk (8) in das erste Netzwerk umwandelt,

und wobei der zweite Zustand des Schalters das elektrische Netzwerk (8) in das zweite Netzwerk umwandelt,

und wobei der Mikrocontroller (7) die Messung der gemessenen Werte ausführt, und

wobei der Mikrocontroller (7) ebenfalls die Schritte des Berechnens der isolationswiderstandwerte (R1, R2) und des vergleichens derselben mit vordefinierten Alarmniveaus ausführt,

und wobei der Mikrocontroller (7) ebenfalls den Schritt des Ausführens einer Alarmaktion auslöst, wenigstens durch Öffnen des Hauptschalters (2) der Gleichstromquelle (1).

8. Vorrichtung nach Anspruch 7, wobei der Schalter (6) ein Transistor (Q1) ist, und wobei das elektrische Netzwerk (8) umfasst:

- einen Widerstand (R3), welcher zwischen dem positiven Anschluss der Quelle (1) und Schutzerdung (4) verbunden ist,
- ein erstes Paar von widerständen (R4, R8), in Serie, welche zwischen dem negativen Anschluss der Quelle (1) und Schutzerdung (4) verbunden sind,
- einen Widerstand (R7), welcher in Serie mit dem Transistor (Q1) angeordnet ist, derart, dass die Serienschaltung des Widerstands (R7) und des Transistors (Q1) parallel angeordnet ist, mit dem ersten Paar von Widerständen (R4, R8), in Serie,
- einen Kondensator (C1), parallel mit dem Widerstand (R7) und dem Transistor (Q1),
- ein zweites Paar von widerständen (R5, R6), in Serie, wobei das zweite Paar von Widerständen (R5, R6) mit der Quelle (1) verbunden ist,
- eine Verbindung (10), zwischen dem Mikrocontroller (7) und dem Punkt (16), zwischen den widerständen des ersten Paares von Widerständen (R4, R8), in Serie, zum Messen einer Spannung (V1', V2'),
- eine Verbindung (18), zwischen dem Mikrocontroller (7) und dem Punkt (17), zwischen den widerständen des zweiten Paares von Widerständen (R5, R6), in Serie, und eine Verbindung (19), zwischen dem Mikrocontroller (7) und dem negativen Quellenanschluss, zum Messen einer Spannung (Vm).

9. Vorrichtung nach Anspruch 8, wobei folgende Beziehungen gelten:

$$R4 + R8 = 2*R3$$

$$R7 = 2*R3/3$$

$$R8 = R4/100$$

10. Vorrichtung nach einem der Ansprüche 7 bis 9, wobei der Mikrocontroller (7) derart programmiert oder gestaltet ist, dass die Vorrichtung, wenn sie eingeschaltet wird, den Hauptschalter (2) schließt, wodurch sie die Isolationsfehlerüberwachung startet.

11. Vorrichtung nach einem der Ansprüche 7 bis 10, wobei der Mikrocontroller (7) derart programmiert oder gestaltet ist, dass der Hauptschalter (2) geöffnet wird, wenn der Strom, welcher von der Quelle erzeugt wird, niedriger ist als ein vordefiniertes Niveau.

12. Vorrichtung nach einem der Ansprüche 7 bis 11, ferner umfassend Mittel zum Senden eines Signals niedriger Spannung hin zu einer Last, nach Unterbrechung des Hauptschalters (2) aufgrund eines Isolationsdefekts.

13. Vorrichtung nach einem der Ansprüche 7 bis 12, ferner umfassend Mittel, zum Verbinden der Vorrichtung mit wenigstens einem zusätzlichen Relais (42, 46), wobei der Mikrocontroller (7) programmiert oder gestaltet ist, das/die zusätzliche(n) Relais zu einem gegebenen Zeitpunkt zu betätigen.

14. Verwendung einer Vorrichtung nach Anspruch 13,

- zum Betätigen eines zusätzlichen Relais (46), bevor der Hauptschalter (2) geschlossen wird, wodurch ein Schalter (44) geschlossen wird, zum Reduzieren des Einschaltstroms an einem DC-Bus-Kondensator (33), und/oder
- zum Betätigen eines zusätzlichen Relais (42), nachdem der Hauptschalter (2) geöffnet wird, wodurch ein Schalter (41) geschlossen wird, zum Entladen von Kondensatorspannung an dem DC-Bus.

15. Vorrichtung nach einem der Ansprüche 7 bis 13, wobei der Schalter (6) ein Transistor (Q1) ist.

**Revendications**

1. Procédé pour surveiller des défauts d'isolement apparaissant entre un bus continu et une terre de protection, ledit bus étant connecté à une source de courant continu (1), ledit procédé comprenant les étapes consistant à :

- connecter les bornes de ladite source (1) à la terre de protection (4) par un premier réseau électrique pendant un premier intervalle de temps,
- mesurer au moins une valeur électrique stable (V1', Vdc) se rapportant audit premier réseau, pendant ledit premier intervalle de temps,
- connecter les bornes de ladite source (1) à la terre de protection (4) par un deuxième réseau électrique pendant un deuxième intervalle de temps,
- mesurer au moins une valeur électrique stable (V2', Vdc) se rapportant audit deuxième réseau, pendant ledit deuxième intervalle de temps,
- calculer, à partir desdites valeurs mesurées, les résistances d'isolement (R1, R2) entre chacune des bornes de ladite source (1) et la terre de protection (4),
- comparer lesdites résistances d'isolement (R1, R2) à des niveaux d'alarme prédéfinis,
- effectuer une action d'alarme, lorsque lesdites résistances d'isolement (R1, R2) dépassent des niveaux prédéfinis,

**caractérisé en ce que** :

- un commutateur (6) est utilisé de manière à ce que ladite étape de connexion desdites bornes audit premier réseau soit effectuée en mettant ledit commutateur (6) dans un premier état, et ladite étape de connexion desdites bornes audit deuxième réseau soit effectuée en mettant ledit commutateur (6) dans un deuxième état,
- lesdites valeurs électriques se rapportant auxdits premier et deuxième réseaux sont mesurées au même point de mesure (16), par rapport à la même référence.

2. Procédé selon la revendication 1, dans lequel ladite référence est une terre de protection.

3. Procédé selon la revendication 1, dans lequel ladite action d'alarme est la déconnexion de ladite source (1) des charges connectées à ladite source.

4. Procédé selon l'une quelconque des revendications précédentes, dans lequel la valeur de résistance R1.R2/(R1+R2) équivalente à la connexion en parallèle desdites valeurs de résistance (R1, R2) est comparée à un niveau d'alarme pour ladite valeur équivalente à ladite connexion en parallèle.

5. Procédé selon l'une quelconque des revendications précédentes, dans lequel lesdites valeurs mesurées sont des tensions mesurées.

6. Procédé selon l'une quelconque des revendications précédentes, dans lequel lesdits premier et deuxième intervalles de temps sont identiques, et dans lequel la séquence desdits premier et deuxième intervalles de temps est répétée selon une fréquence déterminée, et dans lequel lesdites étapes de mesure, de calcul et de comparaison sont répétées selon ladite même fréquence.

7. Dispositif essentiellement pour surveiller des défauts d'isolement apparaissant entre un bus continu et une terre de protection, ledit bus étant connecté à une source de courant continu (1), connectée à un commutateur principal (2), selon le procédé de l'une quelconque des revendications précédentes, ledit dispositif comprenant :

- un commutateur (6)
- un réseau électrique (8), connecté audit commutateur (6),
- un microcontrôleur (7), capable de commander ledit commutateur (6) par l'intermédiaire d'une connexion (9), ledit microcontrôleur comprenant des moyens pour mesurer une valeur électrique,
- au moins une connexion (10) entre ledit réseau (8) et ledit microcontrôleur (7), chaque connexion étant utilisée pour mesurer une valeur,
- des moyens pour connecter ledit dispositif aux bornes de ladite source (1), à la terre de protection (4), et à un relais (3) qui commande ledit commutateur principal (2),

dans lequel le premier état dudit commutateur (6) transforme ledit réseau électrique (8) en ledit premier réseau,
et dans lequel le deuxième état dudit commutateur transforme ledit réseau électrique (8) en ledit deuxième réseau,
et dans lequel ledit microcontrôleur (7) effectue ladite mesure desdites valeurs mesurées, et
dans lequel ledit microcontrôleur (7) effectue également lesdites étapes de calcul des valeurs de résistance d'isolement (R1, R2) et de leur comparaison à des niveaux d'alarme prédéfinis,
et dans lequel ledit microcontrôleur (7) active également ladite étape d'exécution d'une action d'alarme, au moins en ouvrant le commutateur principal (2) de ladite source de courant continu (1).

8. Dispositif selon la revendication 7, dans lequel ledit commutateur (6) est un transistor (Q1), et dans lequel ledit réseau électrique (8) comprend :

- une résistance R3 connectée entre la borne positive de la source (1) et la terre de protection (4),
- une première paire de résistances (R4, R8) en série, connectées entre la borne négative de la source (1) et la terre de protection (4),
- une résistance (R7), placée en série avec ledit transistor (Q1), de sorte que la connexion série de ladite résistance (R7) et dudit transistor (Q1) soit placée en parallèle à ladite première paire de résistances (R4, R8) en série,
- un condensateur (C1) en parallèle avec ladite résistance (R7) et ledit transistor (Q1),
- une deuxième paire de résistances (R5, R6) en série, ladite deuxième paire de résistances (R5, R6) étant connectés à la source (1),
- une connexion (10) entre le microcontrôleur (7) et le point (16) entre les résistances de ladite première paire de résistances (R4, R8) en série, pour mesurer une tension (V1', V2'),
- une connexion (18) entre le microcontrôleur (7) et le point (17) entre les résistances de ladite deuxième paire de résistances (R5, R6) en série, et une connexion (19) entre le microcontrôleur (7) et la borne de source négative, pour mesurer une tension (Vm).

9. Dispositif selon la revendication 8, dans lequel les relations suivantes sont vraies :

$$R4 + R8 = 2 * R3$$

$$R7 = 2 * R3/3$$

$$R8 = R4/100.$$

10. Dispositif selon l'une quelconque des revendications 7 à 9, dans lequel le microcontrôleur (7) est programmé ou conçu de sorte que le dispositif, lorsqu'il est activé, ferme le commutateur principal (2), débutant de ce fait ladite surveillance de défaut d'isolement.

11. Dispositif selon l'une quelconque des revendications 7 à 10, dans lequel le microcontrôleur (7) est programmé ou conçu de manière à ce que ledit commutateur principal (2) soit ouvert lorsque la puissance générée par ladite source est inférieure à un niveau prédéfini.

12. Dispositif selon l'une quelconque des revendications 7 à 11, comprenant en outre des moyens pour envoyer un signal basse tension vers une charge, après une interruption dudit commutateur principal (2) du fait d'un défaut d'isolement.

13. Dispositif selon l'une quelconque des revendications 7 à 12, comprenant en outre des moyens pour connecter ledit dispositif à au moins un relais (42, 46) supplémentaire, et dans lequel ledit microcontrôleur (7) est programmé ou conçu pour actionner ledit ou lesdits relais supplémentaires à un instant donné.

14. Utilisation d'un dispositif selon la revendication 13,

- pour actionner un relais (46) supplémentaire avant la fermeture du commutateur principal (2), fermant de ce fait un commutateur (44), pour réduire le courant d'appel sur un condensateur de bus continu (33), et/ou

- pour actionner un relais (42) supplémentaire après l'ouverture du commutateur principal (2), fermant de ce fait un commutateur (41), pour décharger la tension capacitive sur le bus continu.

15. Dispositif selon l'une quelconque des revendications 7 à 13, dans lequel ledit commutateur (6) est un transistor (Q1).

FIG. 1

FIG. 2

FIG. 3

FIG. 4

EP 1 265 076 B1

15

**EP 1 265 076 B1**

**Patent documents cited in the description**

- EP 0654673 A

- EP 833423 A